(19) Europäisches Patentamt

European Patent Office

Office européen des brevets

(11) **EP 4 718 172 A1**

(12) **EUROPEAN PATENT APPLICATION**

(43) Date of publication:
**01.04.2026 Bulletin 2026/14**

(21) Application number: **24203556.6**

(22) Date of filing: **30.09.2024**

(51) International Patent Classification (IPC):
*G04F 5/14* (2006.01)    *B82B 1/00* (2006.01)
*B82Y 10/00* (2011.01)    *B82Y 20/00* (2011.01)
*G06N 10/40* (2022.01)    *G21K 1/00* (2026.01)
*H03L 7/26* (2006.01)

(52) Cooperative Patent Classification (CPC):
**G04F 5/14; B82B 1/001; G21K 1/20; G21K 1/30;
H03L 7/26;** B82Y 10/00; B82Y 20/00

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicants:
• **Deutsche Telekom AG
53113 Bonn (DE)**
• **Technische Universität Dresden, Körperschaft
des
öffentlichen Rechts
01069 Dresden (DE)**

(72) Inventors:
• **KIM, Ju Hoon
14947 Nuthe-Urstromtal (DE)**
• **YIN, Ming
16341 Panketal (DE)**
• **HOLSCHKE, Oliver
10969 Berlin (DE)**
• **NANDE, Swaraj Shekar
01187 Dresden (DE)**
• **BASSOLI, Ricardo
01067 Dresden (DE)**
• **FITZEK, Frank H. P.
01187 Dresden (DE)**

(74) Representative: **2SPL Patentanwälte PartG mbB
Landaubogen 3
81373 München (DE)**

(54) **OPTICAL LATTICE CLOCK, USE, CELLULAR NETWORK, METHOD**

(57)    Provided is an optical lattice clock. The optical lattice clock includes multiple optical resonators. The optical lattice clock further includes an optical system configured to pump photons into the optical resonators to form an optical lattice in each of the optical resonators for spatially trapping non-linear atoms in the optical resonators. The optical system is configured to pump the photons based on two-photon losses in the optical lattice clock to drive the non-linear atoms in the optical resonators into synchronized limit cycle oscillations . The optical lattice clock is further configured to generate a clock signal based on a probed clock transition of the non-linear atoms. The clock transition is probed when the limit cycle oscillations of the non-linear atoms in the optical resonators are synchronized.

FIG. 1

EP 4 718 172 A1

**Description**

**Field**

The present disclosure relates to an optical lattice clock, a use of a clock signal, a cellular network, and a method.

**Background**

Optical lattice clocks may refer to a type of atomic clock that use optical frequencies to achieve precise timekeeping. Unlike traditional atomic clocks, which are based on microwave transitions in, for example, cesium atoms, optical lattice clocks may use transitions in neutral atoms, such as Strontium or Ytterbium, that occur at higher frequencies. These higher frequencies may allow for more precise measurement of time intervals.

Basic operation of an optical lattice clock may involve trapping atoms in a periodic potential created by laser light, also referred to as an optical lattice. The lattice may confine the atoms in such a way that their motion is restricted. A laser that is stabilized to a narrow atomic transition frequency may be used to probe the atoms, and the frequency of this laser is compared to a reference frequency provided by the atomic transition.

Optical lattice clocks may be used for various applications, including fundamental physics research, geodesy, and potential future redefinitions of the SI second.

**Summary**

According to a first aspect, the present disclosure relates to an optical lattice clock. The optical lattice clock comprises multiple optical resonators and an optical system configured to pump photons into the optical resonators to form an optical lattice in each of the optical resonators for spatially trapping non-linear atoms in the optical resonators. The optical lattice clock is configured to pump the photons based on two-photon losses in the optical resonators to drive the non-linear atoms in the optical resonators into synchronized limit cycle oscillations. The optical lattice clock is further configured to generate a clock signal based on a probed clock transition of the non-linear atoms when the limit cycle oscillations of the non-linear atoms in the optical resonators are synchronized.

By considering two-photon losses, a more precise optical lattice clock may be provided.

In some examples, the optical system is configured to pump the photons further based on single-photon losses of the non-linear atoms to drive the non-linear atoms in the optical resonators into the synchronized limit cycle oscillations.

Thereby, precision of the clock signal may be further enhanced.

In some examples, the optical system is configured to pump the photons using a computational model that receives the single-photon losses and two-photon losses as input. In such examples, the computational model is configured to model Lindblad dissipative processes for single-photon losses and two-photon losses of the non-linear atoms and to model Hamiltonian dynamics of the non-linear atoms.

Thereby, precision of the clock signal may be further enhanced.

In some examples, the non-linear atoms are Thulium atoms.

Thereby, non-linear optical properties of Thulium atoms can be exploited to obtain a precise clock signal.

In some examples, the pumped photons have a wavelength of 814.5 nm.

Thereby, the magic frequency of Thulium atoms is applied to obtain stable dynamics of the optical lattice clock.

In some examples, the measured clock transition is at 1.14 $\mu$m.

Thereby, a precise clock signal may be obtained.

In some examples, for pumping the photons, the optical system is configured to continuously adjust at least one parameter of the optical system.

In some examples, the optical system comprises a lattice laser configured to emit a laser beam. The optical system further comprises optical components configured to guide the laser beam of the lattice laser along a respective optical path from the laser to a respective one of the multiple optical resonators for pumping the photons into the optical resonators. In such examples, the at least one parameter is at least one of a parameter of the laser beam and a parameter of the respective optical path.

Thereby, a coupling of the laser beam into the optical resonators may be enhanced to achieve more stable oscillations.

In some examples, the optical lattice clock is further configured to estimate the two-photon losses based on a measured property of the laser beam.

Thereby, the photon pumping may be controlled more precisely.

In some examples, for generating the clock signal, the optical lattice clock is configured to tune, until a predefined criterion is satisfied, a frequency of a laser beam of a clock laser used for probing the non-linear atoms. In such examples, the optical lattice clock is further configured to generate a timing reference signal based on counted oscillations of the laser beam of the clock laser. The counted oscillation are counted when the predefined criterion is satisfied. In such examples, the optical lattice clock is further configured to down-convert the timing reference to obtain a down-converted timing reference signal. In such examples, the optical lattice clock is further configured to quantize the down-converted timing reference signal to obtain a quantized timing reference signal. In such examples, the optical lattice clock is further configured to filter the quantized timing reference signal to obtain the clock signal.

Thereby, the clock signal may be usable for cellular networks or other applications.

In some examples, the multiple optical resonators are at least three optical resonators.

Thereby, three qubits may be provided and a more precise clock signal may be achieved.

In some examples, the clock signal is generated for use in a cellular network.

Thereby, a cellular network may be provided with a precise clock.

In some examples, the optical lattice clock is further configured to transmit the clock signal to a network component of a cellular network.

Thereby, a cellular network may be provided with a precise clock.

According to a second aspect, the present disclosure relates to a use of a clock signal generated by an optical lattice clock according to the first aspect (or according to at least one example relating to the first aspect) for providing a network function in a cellular network.

Thereby, similar effects as described above may be achieved.

According to a third aspect, the present disclosure relates to a cellular network comprising an optical lattice clock according to the first aspect (or according to at least one example relating to the first aspect).

Thereby, similar effects as described above may be achieved.

In some examples, the cellular network further comprises a network component configured to receive the clock signal from the optical lattice clock and provide a network function of the cellular network based on the clock signal.

Thereby, an enhanced network function may be provided.

According to a fourth aspect, the present disclosure relates to a method for operating an optical lattice clock. The method comprises pumping photons into multiple optical resonators to form an optical lattice in each of the optical resonators for spatially trapping non-linear atoms in the optical resonators. The photons are pumped based on two-photon losses in the optical lattice clock to drive the non-linear atoms in the optical resonators into synchronized limit cycle oscillations. The method further comprises generating a clock signal based on a probed clock transition of the non-linear atoms. The clock transition is probed when the limit cycle oscillations of the non-linear atoms in the optical resonators are synchronized.

Thereby, similar effects as described above may be achieved.

**Brief description of the Figures**

Some examples of apparatuses and/or methods will be described in the following by way of example only, and with reference to the accompanying figures, in which

Fig. 1 depicts an optical lattice clock according to the present disclosure;

Fig. 2 depicts a cellular network according to the present disclosure;

Fig. 3 depicts a flowchart of method for operating an optical lattice clock according to the present disclosure;

Fig. 4 depicts a sequence diagram of a method for operating an optical lattice clock according to the present disclosure; and

Fig. 5 depicts a flowchart of a method for generating a clock signal based on synchronized limit cycle oscillations.

**Detailed Description**

Some examples are now described in more detail with reference to the enclosed figures. However, other possible examples are not limited to the features of these embodiments described in detail. Other examples may include modifications of the features as well as equivalents and alternatives to the features. Furthermore, the terminology used herein to describe certain examples should not be restrictive of further possible examples.

Throughout the description of the figures same or similar reference numerals refer to same or similar elements and/or features, which may be identical or implemented in a modified form while providing the same or a similar function. The thickness of lines, layers and/or areas in the figures may also be exaggerated for clarification.

When two elements A and B are combined using an "or", this is to be understood as disclosing all possible combinations, i.e. only A, only B as well as A and B, unless expressly defined otherwise in the individual case. As an alternative wording for the same combinations, "at least one of A and B" or "A and/or B" may be used. This applies equivalently to combinations of more than two elements.

If a singular form, such as "a", "an" and "the" is used and the use of only a single element is not defined as mandatory either explicitly or implicitly, further examples may also use several elements to implement the same function. If a function is described below as implemented using multiple elements, further examples may implement the same function using a single element or a single processing entity. It is further understood that the terms "include", "including", "comprise" and/or "comprising", when used, describe the presence of the specified features, integers, steps, operations, processes, elements, components and/or a group thereof, but do not exclude the presence or addition of one or more other features, integers, steps, operations, processes, elements, components and/or a group thereof.

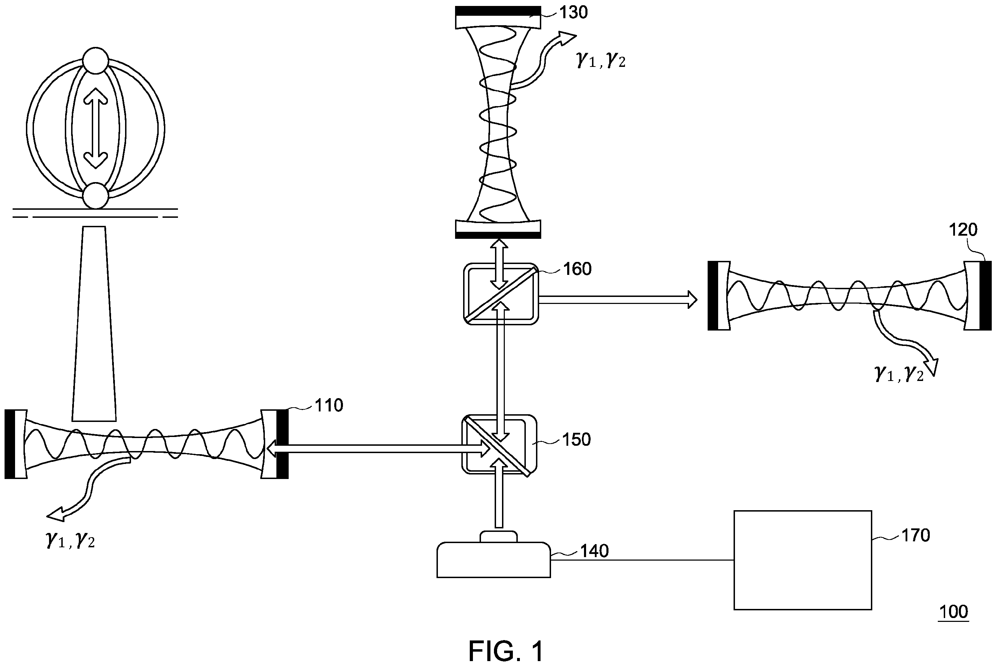

Fig. 1 depicts an optical lattice clock 100 according to the present disclosure. The optical lattice clock 100 includes multiple resonators 110, 120, and 130. In this example, the number of resonators is three resonators, but the present disclosure is not limited in that regard since also one, two, or more than three resonators (such as four) may be used. The resonators 110, 120, and 130 may be any type of resonators into which one or more laser beams can be coupled to trap and excite particles (or atoms), such as high-finesse optical cavities, Fabry-Pérot cavities, mode-cleaning cavities, whispering gallery mode (WGM) resonators, ring, resonators, monolithic resonators, photonic crystal resonators, opto-mechanical resonators, external enhancement cavities, or the like.

Inside the optical resonators 110, 120, and 130, an optical lattice is formed when photons (e.g., based on a lattice laser beam) are pumped into the optical resonators in a predetermined way. Accordingly, the optical lattice clock 100 further includes an optical system configured to pump photons into the optical resonators to form an optical lattice in each of the optical resonators for spatially trapping non-linear atoms in the optical resonators. In this example, the optical system includes a lattice laser 140 and two beam splitters 150 and 160. The optical system may be arbitrarily complex and the present disclosure is not limited to any configuration of the optical system. Fig. 1 only depicts a simplified illustration of the optical system (and also of the resonators).

Also, the lattice laser 140 is not limited to any type of laser and to any number of lasers that are used. For example, multiple lasers may be utilized for different purposes and according to the circumstances, such as a cooling laser for cooling and trapping the particles/atoms, a repumping laser, a clock laser, a frequency comb laser, and the like. However, for creating the optical lattice (when the atoms are prepared, e.g., based on laser cooling), in some examples, only the lattice laser 140 may be used, i.e., a single-source electromagnetic field may be used to control the atomic positions and induce collective frequency oscillations.

Accordingly, different types of lasers may be used for the different purposes, such as an (external cavity or narrow-linewidth) diode laser (e.g., for cooling, trapping, repumping, as clock laser to probe/achieve the desired transition), a fiber laser (e.g., for repumping or as lattice laser), a titanium sapphire laser (e.g., as lattice laser), a laser-locked system (e.g., as clock laser), a solid-state laser (e.g., as clock laser), or the like.

Also, the beam splitters or other optical elements shall not be understood as limiting. For example, the beam splitters 150 and 160 may be one or more of plate beam splitters, cube beam splitters, pellicle beam splitters, polarizing beam splitters, non-polarizing beam splitters, variable beam splitters, or the like. Further optical elements may be provided, in some examples, such as mirrors, lenses, prisms, diffraction gratings, filters, waveplates, optical isolators, fibers, apertures, attenuators, and the like, without limiting the present disclosure in that regard.

Photon pumping may refer to a process where photons from an external light source (e.g., the lattice laser 140) excite the atoms or molecules (i.e., the non-linear atoms, in the present example) in a medium (i.e., in the resonators 110, 120, 130) to higher energy states, creating a population inversion (a condition in which more atoms or molecules in the medium are in an excited energy state than in a lower energy state).

An optical lattice may refer to a periodic potential formed by the interference of counter-propagating laser beams in the resonators 110, 120, and 130 which create a grid-like pattern of light intensity. This pattern may trap (i.e., spatially/locally confine) and manipulate the atoms or molecules (e.g., the non-linear atoms in the present example) at intensity minima or maxima, depending on the atomic/molecular properties.

In other words, based on the pumped photons, an optical lattice is formed in each of the optical resonators for spatially trapping the non-linear atoms in the optical resonators 110, 120, 130.

A non-linear atom may refer to an atomic system whose response to external fields (e.g., electromagnetic field) is not directly proportional to the field's strength, leading to non-linear optical effects such as multi-photon loss, frequency conversion, or self-focusing. These effects may arise due to higher-order interactions between the atomic energy levels and the applied fields, e.g., facilitated by strong laser light or intense fields. For example, Rydberg atoms may exhibit strong dipole-dipole interactions. Moreover, atoms in Bose-Einstein condensates may display non-linear dynamics. Also, Alkali atoms like Rubidium may exhibit non-linear behavior by due to two-photon absorption. Furthermore, atoms interacting with intense laser fields in a Kerr medium may be non-linear atoms, as well as ions in ion traps experiencing non-linear Stark shifts.

For example, linear atoms may have a straightforward, predictable interaction with electromagnetic fields. Their energy levels shift linearly with changes in the field. This predictable behavior may make them easier to manipulate and control, which is crucial for maintaining the stability and accuracy of atomic clocks, such as Cesium clocks. Linear atoms may be used in conventional atomic clocks because their responses may be easy to manage. On the other hand, non-linear Atoms exhibit more complex interactions with electromagnetic fields. Their energy levels do not shift linearly with changes in the field. Instead, they may exhibit non-linear behaviors. This can make them more challenging to control precisely. However, non-linear atoms may be more sensitive or may be better (than non-linear atoms) in compensating for environmental noise.

In some examples, the non-linear atoms (in the resonators 110, 120, 130) are Thulium atoms, but the present disclosure is not limited in that regard since Ytterbium or Strontium may be used. Also, other non-linear atoms may be used since the principles (and the equations) of the present disclosure may be applied in general to non-linear atoms or particles, molecules, etc.

Optionally, the optical lattice clock may further include control circuitry 170 configured to control or adjust the various elements of the optical lattice clock 100 (e.g., the lattice laser 140, as shown in Fig. 1, but also other elements may be controlled by the control circuitry 170) to carry out the functions or actions described herein. The control circuitry 170 may be a single dedicated processor, a single shared processor, or a plurality of individual processors, some of which or all of which may be shared, a digital signal processor (DSP) hardware, an application specific integrated circuit (ASIC), a neuromorphic processor or a field programmable gate array (FPGA). The control circuitry 170 may optionally be coupled to, e.g., read only memory (ROM) for storing software, random access memory (RAM) and/or non-volatile memory. Additionally or alternatively, a ramp generator, a phase-lock loop, or the like may be included in the control circuitry.

The optical system is configured to pump the photons based on two-photon losses in the optical lattice clock. In some examples, the optical system is further configured to pump the photons based on one-photon losses, as discussed below.

A two-photon loss (or double-photon loss) may refer to a process in which two photons are lost simultaneously from the optical lattice clock, which may happen when entangled photons are emitted (from a quantum source, such as an excited atom falling into a lower energy state) and are then lost (independently). Photons may be lost due to absorption, scattering, or imperfections in optical fibers or optical components. On the other hand, a single-photon loss (or one-photon loss) may refer to a loss of a single emitted photon.

Such photon losses may (significantly) reduce fidelity and quality of quantum systems and may need to be mitigated for reliable operation. In the present disclosure, the photons may be lost from the resonators 110, 120, 130 and are compensated for by the pumping photons by the lattice laser 140.

The two-photon losses (and also other types of photon losses such as one-photon losses) may be measured, estimated, computed, modeled, or the like. In some examples, the optical lattice clock 100 is configured to estimate the two-photon losses based on a measured property of a laser beam (of the lattice laser 140). The measured property of the laser beam may be any measurement that allows for determining an energy difference of an energy that is fed into the optical lattice clock versus an energy that is actually absorbed by the optical lattice clock. For example, if the intensity of the laser beam is known/measured, a total emitted light energy may be determined and be compared to a total (estimated) energy that the (remaining) system absorbs or uses. Based on an energy difference, it can be inferred how many photons have been lost. Furthermore, the photon losses may be determined based on a model that takes into account the laser's intensity.

For measuring the photon losses, the optical lattice clock 100 may in some examples comprise corresponding detectors. For example, photon counters may be applied, such as single-photon detectors (e.g., avalanche photodiodes, superconducting nanowire detectors, single photon avalanche diodes, or the like) which (directly) measure the number of photons exiting the system. By comparing the number of photons injected into the system to those detected after the interaction, an estimate of the loss may be determined. Such photon counters may be positioned where photon leakage or scattering is likely to occur.

Also, cavity decay time (Ring-Down Measurement) may be determined. In systems like optical cavities (or the resonators 110, 120, 130), photon losses may be inferred by measuring the decay time of light inside the cavity, as discussed above under reference of equation (2). After the input light is switched off, the light intensity inside the cavity decays as photons escape or are absorbed. This decay time, known as the ring-down time, may be used to calculate the photon loss rate. For example, the faster the decay, the greater the photon losses. The photon loss rate(s) for the system may be determined in advance and used as a constant for the Lindblad master equation.

Moreover, in systems where two or more photons are expected to behave in correlated ways (such as in entangled states), a decrease in correlation between detected photons may indicate photon losses. For example, in a Hanbury Brown and Twiss (HBT) experiment, correlations between two detectors are measured. A decrease in expected correlations (i.e., missing coincidence events) may indicate photon loss.

Photon losses may further be detected by comparing an input power (number of photons entering the optical system and the resonators) to the output power (number of photons detected after transmission by the lattice laser 140 and the optical system). The difference between the input and output provides a measure of the photon loss due to absorption, scattering, or other loss mechanisms.

The photon pumping based on the two-photons losses is done to drive the non-linear atoms in the optical resonators 110, 120 and 130 into synchronized limit cycle oscillations (or a limit cycle state or a steady state). In other words, by driving the non-linear atoms in the optical resonators 110, 120 and 130 into a limit cycle state, the oscillations of the non-linear atoms in the optical resonators 110, 120 and 130 are synchronized such that (e.g., substantially all or at least a majority of) the non-linear atoms in the optical resonators 110, 120 and 130 perform the synchronized limit cycle oscillations.

A limit cycle state may refer to a stable, closed trajectory in a phase space of a dynamical system (i.e., in the atomic system of Fig. 1), where the system's state variables oscillate with a fixed amplitude and period. In contrast to equilibrium states, a limit cycle represents sustained periodic behavior that can attract nearby trajectories, making it robust to small disturbances. In the context of the present disclosure, limit cycle oscillations may refer to oscillations of the atoms between a ground state and an excited state. These limit cycle oscillations may be stable. The energy difference between the ground state and the excited state may correspond to a clock transition of the atoms, as will be discussed below. The limit cycle oscillations may be synchronized, i.e., each of the atoms ideally oscillates simultaneously while being trapped in the optical lattice.

Regarding the stability of the limit cycle oscillations, the non-linear atom may have locked its movement to make this limit cycle oscillation possible, as it also attracts other trajectories of phase space. Hence, the limit cycle oscillations may be stable in the sense that, if any atom that is not (yet) exhibiting this limit cycle oscillation, will also tend exhibit limit cycle oscillation. When the non-linear atom has locked its dynamics to exhibit limit cycle oscillation, intra-atomic transitions may be (accurately) targeted and for the clock transition, it may be assumed that the non-linear atom is in the ground state.

In other words, stability may refer to attraction of trajectories of other atoms in the phase space.

In some examples, the optical system is configured to pump the photons further based on single-photon losses (as indicated above) of the non-linear atoms to drive the non-linear atoms in the optical resonators into the limit cycle state. One-photon losses may be the type of photon loss which may happen more frequently than a two-photon loss (or even a multi-photon loss). However, considering both single-photon loss and two-photon loss may lead to a more exact pumping and thus, to a more exact optical lattice clock (or a more exact clock signal).

In some examples, optical system is configured to pump the photons using a computational model that receives the single-photon losses and two-photon losses as input. The computational model is configured to model Lindblad dissipative processes for single-photon losses and two-photon losses of the non-linear atoms and to model Hamiltonian dynamics of the non-linear atoms, as discussed under reference of equations (1) and (2) below. The computational model may refer to a computer program or algorithm which takes as input the single- and two-photon losses and based on which a control signal is generated to tune the lattice laser 140 or any optical element that is used to pump the photons into the resonators 110, 120, and 130.

An example of a mathematical description (e.g., for the computational model) of the system of Fig. 1 is given in the following. The mathematical description is based on Hamiltonian dynamics and a Lindblad Master equation describing a Lindblad dissipative process.

The Hamiltonian may be formulated as follows:

$$\widehat{H} = \hbar\omega_0\left(\hat{n} + \frac{1}{2}\right) + \frac{\sum_{i=1}^{n}\hbar\Omega_i\hat{\sigma}_z^{(i)}}{2} + g\hbar\omega_0\sum_{i=1}^{n}\hat{\sigma}_x^{(i)}(\hat{a} + \hat{a}^\dagger) + f\cos(\omega t)(\hat{a} + \hat{a}^\dagger) \qquad (1)$$

In equation (1), the term $\hbar\omega_0\left(\hat{n} + \frac{1}{2}\right)$ represents energy levels of a quantum harmonic oscillator with $\omega_0$ being determined by the resonance frequency of the optical lattice trap used to trap the non-linear atoms and $\hat{n}$ being a number operator representative of the number of photons in the oscillator mode which can be controlled experimentally by adjusting intensity of the trapping laser. The number operator further represents quantized energy levels in the harmonic oscillator. Moreover, $\hbar\omega_0$ represents the energy scale (i.e., energy spacing between excitations levels). $\frac{\sum_{i=1}^{n}\hbar\Omega_i\hat{\sigma}_z^{(i)}}{2}$ represent single qubit terms, i.e., energy of each qubit (each resonator may constitute a qubit). $\Omega_i$ represents a frequency associated with the i-th qubit controlled by the external field (e.g., the lattice laser 140 or an external electromagnetic field or microwave driving frequency). $\sigma_z^{(i)}$ is the Pauli Z-operator which represents the spin state of the i-th qubit which is manipulated by the external field. $g\hbar\omega_0\sum_{i=1}^{n}\hat{\sigma}_x^{(i)}(\hat{a} + \hat{a}^\dagger)$ is an interacting term describing the coupling between the qubits and the harmonic oscillator. g represents a coupling strength which depends on a spatial overlap between the qubits and the harmonic oscillator mode, which can be tuned by adjusting the position and intensity of the lasers, for example.

$\hat{\sigma}_x^{(i)}$ (Pauli X-operator) may be manipulated by applying an external resonant microwave/optical field. $\hat{a}$ is a creation operator and $\hat{a}^\dagger$ is an annihilation operator. The term $g\hbar\omega_0 \sum_{i=1}^{n} \hat{\sigma}_x^{(i)}(\hat{a} + \hat{a}^\dagger)$ is non-linear as it involves the product of the Pauli operator (which has Eigenvalues 1 and -1) and the creation/annihilation operators.

$f\cos(\omega t)(\hat{a} + \hat{a}^\dagger)$ is a driving field term which represents the external field applied to the system. $f$ is the amplitude of the driving field, controlled by the power of the laser or microwave source, $\omega$ is the frequency of the driving field which is chosen based on the desired resonance condition for the system. This term may lead to non-linear behavior, especially when the driving amplitude f is large (e.g., above a threshold). The cosine function modulates the interaction, leading to time-dependent non-linearity in the system.

The Lindblad Master equation describes a time evolution of a density matrix ρ of the system. The density matrix ρ may be represented as a tensor of rank 2n (n is the number of atoms). Each tensor element may correspond to a probability amplitude for the system being in a specific combination of atomic states.

The Lindblad master equation is a differential equation that describes how an open quantum system's density matrix evolves over time. This equation may be used for the study of quantum systems that interact with their surroundings, resulting in dissipative processes and deco-herence. The Lindblad master equations may expand the Schrödinger equation to include such interactions, such that such interaction may be falsifiable in quantum mechanics and quantum information theory.

The Lindblad master equation of the present disclosure may model dynamics of open quantum system by depicting interactions between the quantum system and its surroundings, such as photon loss and environmental dissipation, which are necessary for the system's operation. Moreover, the Lindblad master equation of the present disclosure may model dissipative processes by characterizing both single- and two-photon loss processes which may be critical for preserving the limit cycle oscillations required for exact synchronization. Furthermore, the Lindblad master equation of the present disclosure may be important for normalization and physical validity by keeping the density matrix normalized throughout the process, ensuring that the quantum state descriptions are physically correct. The Lindblad master equation of the present disclosure is adapted for describing the non-linear interactions between qubits and harmonic oscillator modes, such that femtosecond-level synchronization may be achieved. Also, the Lindblad master equation of the present disclosure may enable real-time analysis and adjustments, thereby achieving system synchronization and stability.

The Lindblad Master equation may be formulated as follows:

$$\frac{d\rho}{dt} = -i[\hat{H}, \rho] + \gamma_1 \left( \hat{a}\rho\hat{a}^\dagger - \frac{1}{2}\{\hat{a}^\dagger\hat{a}, \rho\} \right) + \gamma_2 \left( \hat{a}^2\rho\hat{a}^{\dagger 2} - \frac{1}{2}\{\hat{a}^{\dagger 2}\hat{a}^2, \rho\} \right) \qquad (2)$$

$-i[\hat{H}, \rho]$ describes the unitary evolution governed by the Hamiltonian. It directly relates to all parameters defined in the Hamiltonian (equation (1)) which are controlled through the setup of the optical lattice, lasers, external fields etc. In equation (2), the Hamiltonian operator may be interpreted as governing the coherent part of the system's dynamics and the density matrix may represent the statistical state of the quantum system. $\gamma_1 \left( \hat{a}\rho\hat{a}^\dagger - \frac{1}{2}\{\hat{a}^\dagger\hat{a}, \rho\} \right)$ represents a single photon loss term. $\gamma_1$ represents a decay rate for single-photon losses. $\hat{a}\rho\hat{a}^\dagger$ represents annihilation and creation which describe the loss of photons from the systems. $\gamma_1$ may be determined by the quality of the optical cavity/resonator and the coupling to the environment, which may be influenced by vacuum quality, cavity design, and the like. Moreover, $\frac{1}{2}\{\hat{a}^\dagger\hat{a}, \rho\}$ represents an anticommutator term for ensuring that the trace of $\rho$ remains normalized, which may be critical for the physical validity of the quantum state description. The anticommutator term may be determined by the quality of the optical cavity, coupling to the environment, and the like. $\gamma_2 \left( \hat{a}^2\rho\hat{a}^{\dagger 2} - \frac{1}{2}\{\hat{a}^{\dagger 2}\hat{a}^2, \rho\} \right)$ represents a two-photon loss term with a decay rate for two-photon loss processes of $\gamma_2$. $\gamma_2$ may be influenced by the non-linear optical properties of the system and the design of the optical resonators.

Returning to Fig. 1, the optical lattice clock is further configured to generate a clock signal based on a probed clock transition of the non-linear atoms when the limit cycle oscillations of the non-linear atoms in the optical resonators 110, 120, and 130 are synchronized.

The clock signal may be generated based on a clock laser that is tuned to obtain a clock transition of the non-linear atoms. For example, if the non-linear atoms are Thulium atoms, the clock transition may be 1.14 μm and a laser may be tuned to ca. $2.63*10^{14}$ Hz in order to obtain the clock signal.

For generating the clock signal, the optical lattice clock (or (clock laser) control circuitry - for the term "circuitry", see above) may be configured to tune a frequency of a laser beam of the clock laser used for probing the non-linear atoms.

The tuning may be carried out until a predefined criterion is satisfied. The predefined criterion may indicate or include that a frequency of the laser beam of the clock laser matches a frequency of the clock transition.

The clock laser may probe the atoms trapped in the optical lattice (which may be cooled to have minimal thermal motion, e.g., based on laser cooling). The clock laser, which may be highly stabilized and narrow in linewidth, may be tuned near the frequency of a specific electronic transition in the atoms (i.e., the clock transition). The laser light of the clock laser may be directed at the atoms in the optical lattice. If the clock laser's frequency matches the energy difference between the ground state and the excited state (as a predefined criterion), the atoms absorb the laser light. The energy difference between the ground state and the excited state may also be referred to as the clock transition. The absorption of the clock laser's light may promote the atoms from the ground state to the excited state. The probability of this absorption may depend on how closely the laser's frequency matches the atomic transition frequency.

After probing the atoms with the clock laser, the state of the atoms may be measured. There may be various methods for detecting whether the atoms are in an excited state, such as fluorescence detection, where the atoms emit light when they return to their ground state, or direct detection of state populations. By monitoring how many atoms are excited for a given laser frequency, the system can determine how close the laser frequency is to the true atomic transition. For example, the predefined criterion may include a detection whether population inversion is present, i.e., whether a maximum number of atoms are in the excited state.

After that, frequency scanning may be carried out. The clock laser may be swept (or tuned) across a small range of frequencies around the expected atomic transition. As the frequency is scanned, the optical lattice clock may be configured to record how many atoms are excited at each laser frequency. This may result in a resonance curve or line shape, where the peak of the curve corresponds to the atomic transition frequency.

Furthermore, feedback control may be carried out in that the optical lattice clock is configured to continuously compare the current laser frequency to the atomic transition frequency. If the laser drifts away from the peak resonance frequency, feedback control mechanisms may adjust the laser's frequency to keep it locked to the atomic transition. The feedback system may use a phase-locked loop (PLL) or other control techniques to maintain the laser frequency at the value where maximum atomic excitation occurs.

Once the clock laser is locked to the atomic transition frequency (i.e., when the predefined criterion is satisfied), the number of optical oscillations of the laser's electromagnetic field may be counted. The number of oscillations may be counted to provide an accurate measurement of time. For example, each oscillation corresponds to a fraction of a second, and a total count can be used to define time intervals.

Therefore, in some examples, the optical lattice clock is further configured to generate a timing reference signal based on counted oscillations of the laser beam of the clock laser.

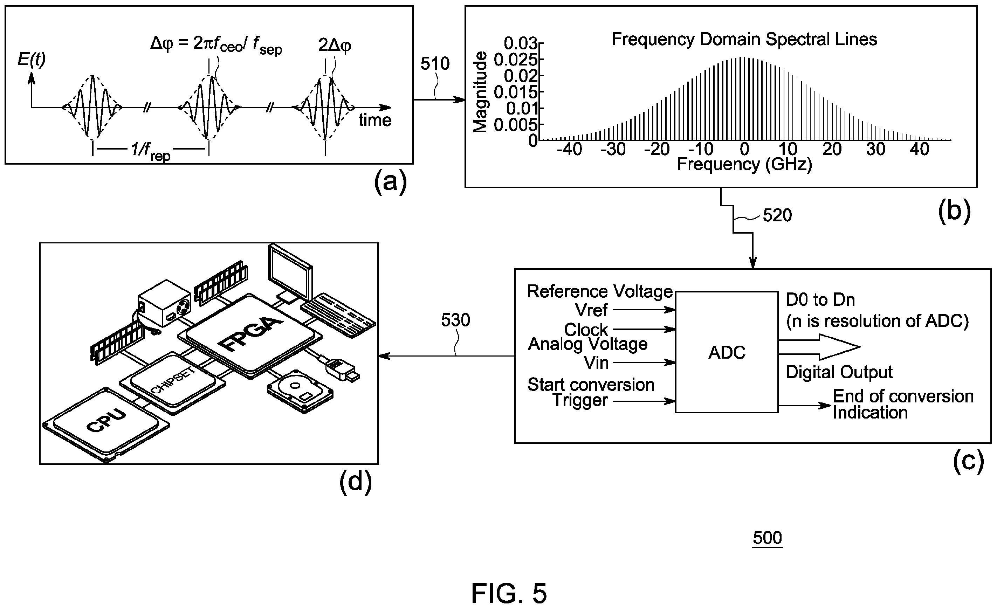

In some examples, for generating the clock signal, optical lattice clock is further configured to down-convert the timing reference signal (representing the measured clock transition of the non-linear atoms) to obtain a down-converted timing reference signal. The optical lattice clock may be further configured to quantize the down-converted timing reference signal to obtain a quantized timing reference signal and filter the quantized timing reference signal to obtain the clock signal. Such an example will be further discussed under reference of Fig. 5.

The clock signal may refer to an electronic signal or waveform used to synchronize the operations of digital circuits (e.g., such as processors and memory), telecommunication networks (or parts of it, such as base stations), ensuring coordinated data transfer and processing. Accordingly, in some examples, the clock signal is generated for use in a cellular network.

The clock signal may serve as a reference that may dictate the rate at which a system's components perform their functions. In cellular networks, the clock signal may refer to a reference signal (e.g., a timestamp) used to synchronize transmission, reception, and processing of data across different network components.

In some examples, the pumped photons have a wavelength of 814.5 nm. This may be the case when Thulium atoms are used in the resonators. This wavelength of 814.5 nm (for Thulium) may also be called magic wavelength, in some examples (other atoms or particles may have other magic wavelengths). Atoms may have multiple electronic states, each with different energy levels. When atoms are trapped in an optical lattice, the light may cause shifts in these energy levels due to the AC Stark effect (or light shift), where the presence of an oscillating electric field (from the laser light) modifies the atomic energy levels. These shifts may vary for different electronic states of the atom. For precision experiments, it may be crucial that the trapping light (i.e., the pumped photons) does not cause differential shifts between the states involved in the measurement or computation. Differential shifts may lead to dephasing or errors in quantum state manipulation, affecting the accuracy and coherence of the system. A magic wavelength (or magic frequency) may thus refer to a frequency of the trapping light where the AC Stark shifts are the same for the specific energy levels being used in the experiment. At this wavelength/frequency, the relative energies between these levels remain unchanged even in the presence of the trapping light. This makes it possible to perform more precise and controlled experiments, as the internal state of the atom is not perturbed by the trapping mechanism.

In some examples, for pumping the photons, the optical system is configured to continuously adjust at least one parameter of the optical system. For example, the laser may be tuned to achieve a predetermined locking frequency (to emit the magic frequency). Moreover, an optical element may be adjusted such as one of the beam splitters 150 or 160. Furthermore, the optical resonators may include a piezo element based on which the resonator length can be adjusted. Also, an (external) laser to determine the clock transition may be tuned.

As indicated above, the optical system of Fig. 1 includes the lattice laser 140 and two beam splitters, but the present disclosure is not limited in that regard. In more general terms, the optical system may include a lattice laser configured to emit a laser beam (the light emitted by the lattice laser 140) and optical components (or optical elements) configured to guide the laser beam of the lattice laser 140 along a respective optical path from the laser to a respective one of the multiple optical resonators 110, 120, 130, for pumping the photons into the optical resonators 110, 120, 130. In such examples, the at least one parameter is at least one of a parameter of the laser beam and a parameter of the respective optical path, as discussed above (e.g., beam splitter, mirror, piezo, lens, and the like). For example, the parameter of the laser beam may be at least one of an intensity, a wavelength, a coherence parameter, a locking mode parameter, a control voltage, a control current, a cooling temperature, and the like. For example, the parameter of the respective optical path may be at least one of a position of an optical element, an angle of an optical element, an alignment of an optical element, a distance between two optical elements, an applied voltage (e.g., of a piezo element), and the like.

The term "optical path" may refer to a route or trajectory that light follows as it travels through an optical system or medium. The optical path may be established by the optical elements. It should be noted that the optical system may have multiple optical paths or that the optical path may be split into multiple optical paths (e.g., by beam splitters). Accordingly, it may be said for Fig. 1, that there are three optical paths, each one leading to a respective resonator 110, 120, or 130. Thereby, the photons may be pumped into each resonator for creating an optical lattice in each resonator.

In some examples, the optical lattice clock 100 is further configured to transmit the clock signal to a network component of a cellular network. The optical lattice clock 100 may include or communicate with a corresponding interface to transmit the clock signal. The interface may depend on the cellular network that is used. For example, the interface 100 may be an X2 interface (e.g., as it is used in LTE (long term evolution) network architecture or any other network architecture), an Abis interface (e.g., as it is used in 2G/GSM network architecture or any other network architecture), an Ater interface (e.g., as it is used in 2G/GSM network architecture or any other network architecture), an Iu interface (e.g., as it is used in 3G/UMTS network architecture or any other network architecture), an Iur interface (e.g., as it is used in 3G/UMTS network architecture or any other network architecture), an NG interface (e.g., as it is used in 5G/NR network architecture or any other network architecture), an Xn interface (e.g., as it is used in 5G/NR network architecture or any other network architecture), an N2 interface (e.g., as it is used in 5G/NR network architecture or any other network architecture), or the like.

Generally, a cellular network may refer to a communication system that uses a grid of interconnected cell towers to provide wireless coverage for mobile devices, such as a mobile telecommunications network. Each cell tower (e.g., base station) may cover a specific area, allowing devices to connect and transfer data as they move between different areas.

As indicated above, the clock signal may oscillate between a high and a low state, creating a regular, predictable pulse that may serve as a timing mechanism to coordinate the flow of digital data. In cellular networks, clock signals may ensure that all elements or network components, such as base stations, network nodes, and mobile devices, operate in precise synchronization. This synchronization may be crucial for maintaining data integrity, reducing latency, and ensuring seamless handovers between cells, as well as supporting time-sensitive operations like packet transmission, modulation, and coding, without limiting the present disclosure in that regard (also other network functions as mentioned above may be provided based on the clock signal).

Some examples pertain to a use of a clock signal generated by an optical lattice clock according to the present disclosure for providing a network function in a cellular network.

The network function may include any function for which a clock signal is needed, such as synchronization, scheduling, handover, time division multiple access, carrier aggregation, frame alignment and transmission, network time protocol, precision time protocol, time-difference of arrival, network slicing, location based services, frequency division duplex coordination, coordinated multipoint, beamforming, multiple input multiple output, interference management, quality of service management, paging, call setup, radio resource management, dynamic spectrum sharing, enhanced mobile broadband, ultra-reliable low latency communication, edge computing coordination, virtualized network function coordination, software-defined networking coordination, carrier frequency offset correction, data encryption and security protocols, multi radio access technology coordination, massive machine-type communication, broadcast service, multicast service, timing advance control, carrier synchronization in heterogeneous networks, small cell coordination, energy efficiency management, timing in device-to-device communication, network load balancing, congestion control, self-organizing networks, physical layer security techniques, timing for artificial intelligence and machine-learning based network functions, clock synchronization, distributed ledger technologies, emergency communication services, priority communication services, and the like.

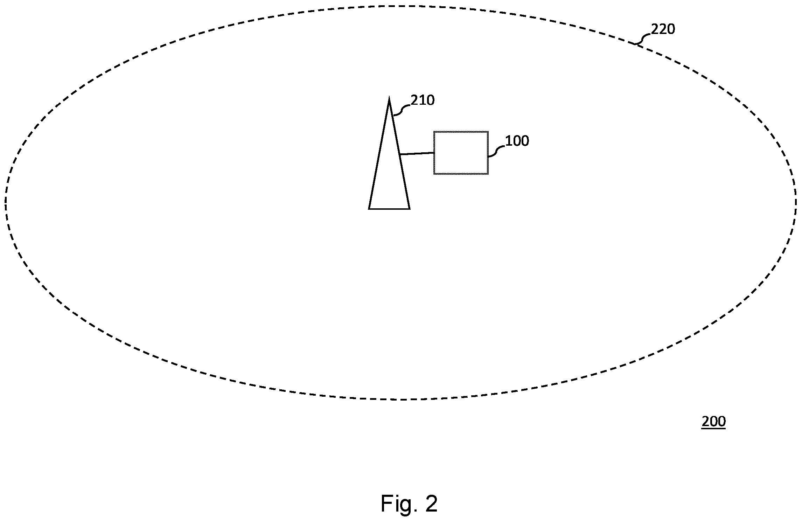

Fig. 2 depicts a cellular network 200 comprising the optical lattice clock 100. As an example, the cellular network 200 further includes a base station 210 that is connected to the optical lattice clock 100. The base station 210 serves a cell 220. It should be noted that the cellular network 200 may include further network components/elements, such as further base stations, further cells, mobile devices, repeaters, and the like.

The base station 210 serves as an example for a network component configured to receive the clock signal from the optical lattice clock 100 provide a network function (e.g., one or more of the network functions mentioned above) of the cellular network based 200 on the clock signal.

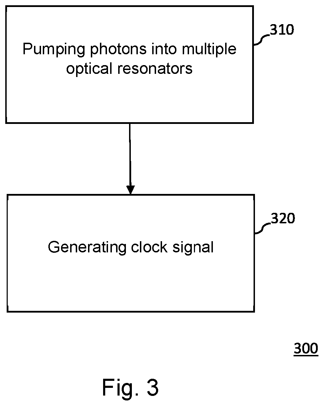

Fig. 3 depicts a flowchart of a method 300 for operating an optical lattice clock (or for generating a clock signal). The method includes pumping, 310, photons into multiple optical resonators to form an optical lattice in each of the optical resonators for spatially trapping non-linear atoms in the optical resonators. The photons are pumped based on two-photon losses in the optical lattice clock to drive the non-linear atoms in the optical resonators into synchronized limit cycle oscillations The method further includes generating, 320, a clock signal based on a probed clock transition. The clock transition is probed when the limit cycle oscillations of the non-linear atoms in the optical resonators are synchronized.

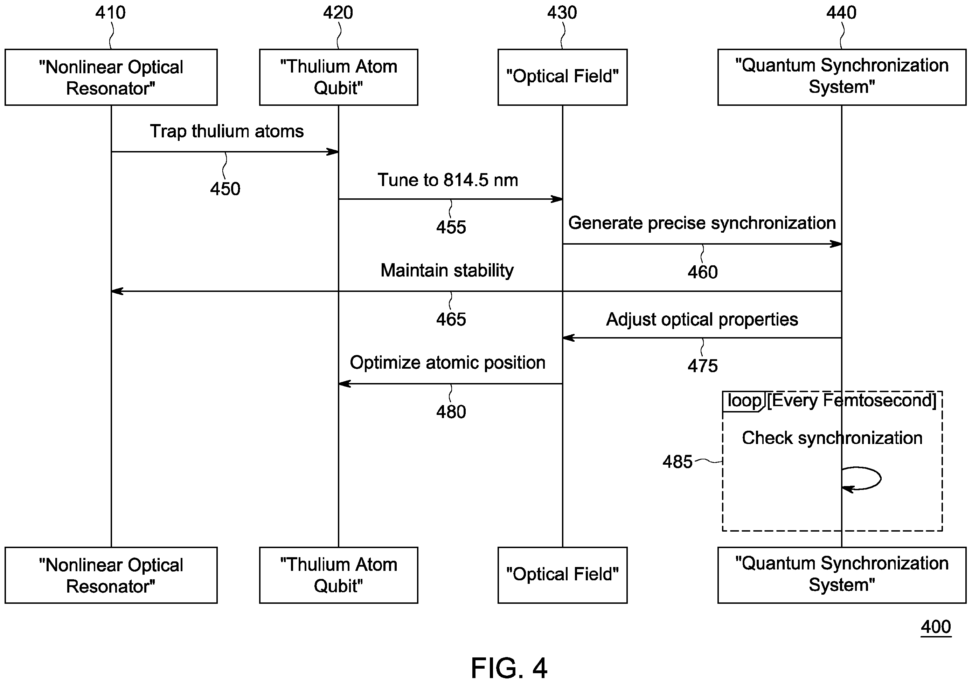

Fig. 4 depicts a sequence diagram of a method 400 for operating an optical lattice clock (or for generating a clock signal) according to the present disclosure.

The method 400 is carried out using a non-linear optical resonator 410 in which Thulium atoms are provided and which constitutes a Thulium atom qubit 420. Moreover, an optical field 430 is applied and a quantum synchronization system 440 (implemented by control circuitry, as discussed herein) is used.

In the non-linear optical resonator 410, Thulium atoms are trapped, 450, to constitute the Thulium atom qubit 420. As discussed above, the optical field 430 is tuned, 455, to a magic frequency of 814.5 nm. When the magic frequency is applied, a precise synchronization is generated, 460, by the quantum synchronization system 440 which maintains, 465, stability in the non-linear optical resonator 410. Moreover, the quantum synchronization system 440 adjusts, 475, optical properties with the optical field 430 and atomic positions are optimized, 480. According to the present disclosure, a femtosecond precision may be achieved and thus, synchronization is checked, 485, by a loop that is carried out each femtosecond.

Fig. 5 depicts a flowchart of a method 500 for generating the clock signal.

Subfigure 5(a) depicts an illustrational example of a timing reference signal according to the present disclosure. The timing reference signal is the measured signal after interaction with the non-linear atoms (i.e., after targeting the clock transition). The analog signal is down-converted, 510.

Signal conversion may be important in the synchronization of optical lattice clocks (or other clocks) over long distances. Given that these clocks operate at high frequencies in the optical range (e.g., hundreds of terahertz or trillions of oscillations per second), transmitting these signals directly over long distances may pose a significant challenge since they may be prone to noise or other disturbances and may be challenging to transmit without loss. Therefore, the high-frequency optical signals from the optical lattice clock are converted into lower-frequency signals, such as microwave signals, which are easier to transmit over long distances. This process is called frequency down conversion.

For the down-conversion 510, initially, the optical signal may be mixed with a local oscillator signal in a non-linear medium to generate an intermediate frequency signal. This signal is then further down converted to a microwave frequency, which can be transmitted more readily through existing telecommunications infrastructure, such as coaxial cables or fiber-optic lines.

Once the signal reaches its destination, it is converted back into an optical signal to be compared with the local clock. This up-conversion process may be the reverse of the frequency down conversion process.

The down-conversion 510 may be carried out based on a frequency comb, without limiting the present disclosure in that regard. Generally, a frequency comb can be utilized to down-convert a femtosecond-level pulse from a Quantum Networked Sensor (QNS) system (i.e., the optical lattice clock), which requires processes and concepts in ultrafast and nonlinear optics. A femtosecond pulse may last $10^{-15}$ seconds. The electric field of a femtosecond pulse can be described as:

$$E(t) = E_0 \exp\left(-\frac{t^2}{2\tau^2}\right) \cos\left(\omega_0 t + \Phi\right) \qquad (3)$$

where $E_0$ is the peak electric field amplitude; $\tau$ is the pulse duration (full-width at half-maximum, FWHM); $\omega_0$ is the central angular frequency of the pulse; and $\phi$ is the phase.

A frequency comb may refer to a spectrum made up of evenly spaced lines that can be formed with a mode-locked laser. The comb's frequencies are described as follows:

$$f_n = f_0 + n f_{rep} \qquad (4)$$

where $f_0$ is an offset frequency; $f_{rep}$ is a repetition rate of the mode-locked laser; and n is an integer representing the position of a line of the frequency comb.

A femtosecond pulse may be down-converted by mixing it with a frequency comb. The goal is to generate a signal with a lower frequency while keeping time information. In non-linear optics, sum-frequency generation (SFG) and difference-frequency generation (DFG) may be used which refer to processes in which two optical fields interact in a nonlinear medium. For down-conversion, DFG may be used for which the resulting frequency may be formulated as:

$$\omega_{DFG} = \omega_1 - \omega_2 \qquad (5)$$

where $\omega_1$ is the frequency of the femtosecond pulse and $\omega_2$ is the frequency of the frequency comb.

Moreover, phase matching may be used for the down-conversion to ensure that the generated waves constructively interfere. The phase matching criteria may be formulated as:

$$k_1 - k_2 = k_{DFG} \qquad (6)$$

where $k_1$ and $k_2$ denote wave vectors at the corresponding frequencies.

The down-conversion 510 may further be represented as follows.

Assume the femtosecond pulse has a Gaussian envelope and is centered at $\omega_0$. The frequency comb includes modes at

$$\omega_n = \omega_0 + n\Delta\omega \qquad (7)$$

An interaction Hamiltonian may be formulated as follows:

$$H_{int} = \chi^2 E_{fs}(t) E_{comb}(t) \qquad (8)$$

where $\chi^2$ a second-order nonlinear susceptibility, $E_{fs}(t)$ is the electric field of the femtosecond pulse and $E_{comb}(t)$ is the electric field of the frequency comb.

The electric field of the frequency comb may be formulated as follows:

$$E_{comb}(t) = \sum_n E_n \cos\left(\omega_n t + \Phi_n\right) \qquad (9)$$

The generated difference frequency field that results from mixing the femtosecond pulse with each mode of the frequency comb can then be formulated as

$$E_{DFG}(t) \propto \chi^2 \sum_n E_n E_{fs} \cos\left[(\omega_0 - \omega_n)t + (\Phi - \Phi_n)\right] \qquad (10)$$

The result of the down-conversion 510 is illustrated in subfigure 5(b) in form of a resulting spectrum. The down-converted signa is then quantized, 520 based on an ADC (analog to digital conversion) as shown in subfigure 5(c).

Analog signals may typically be continuous, such that they can have any value within a certain range. On the other hand, digital signals are discrete, meaning they can only take on certain specific values. In the present disclosure, the process of converting an analog signal to a digital signal is called quantization.

To process the down-converted signal, it is quantized, 520. During the quantization 520, the continuous range of values in the analog signal is divided into a set of discrete levels. The analog signal is then approximated by assigning the value of the nearest one of these discrete levels. Thereby, a digital signal is generated that can be processed, transmitted, or stored using digital technology.

However, quantization may introduce some error, known as quantization noise due to the approximation of the continuous/analog signal with a discrete/digital signal. The degree of this error may depend on the number of discrete levels used in the quantization process, i.e., the more levels, the smaller the quantization noise. High precision of an optical lattice clock may be achieved by keeping the quantization noise to a minimum to preserve the high precision.

As indicated above, ADC is applied for quantizing the signal. The ADC samples the analog signal at a sampling rate or sampling frequency $f_s$. According to the Nyquist theorem (or Nyquist-Shannon theorem), $f_s$ must be at least twice as high as the highest frequency component of the analog signal to avoid aliasing artifacts.

The process is defined by:

$$Q(x) = \Delta \left\lfloor \frac{x}{\Delta} + 0.5 \right\rfloor \qquad (11)$$

where $Q(x)$ is the quantized value, $x$ is the input analog signal, and $\Delta$ is the quantization step size. The step size $\Delta$ may be

related to a bit depth n of the ADC by:

$$\Delta = \frac{V_{max} - V_{min}}{2^n} \tag{12}$$

where $V_{min}$ is a minimum value of an input signal and $V_{max}$ is a maximum value of the input signal.

Precision of such a quantization may be determined by the bit depth of the digital representation, which specifies the number of discrete levels available.

The quantized signal may subsequently be filtered, 530, by filtering circuitry, as illustrated in subfigure 5(d). The filtering 530 is carried out to remove unwanted components from the signal and to prepare it for further processing or transmission. For example, noise reduction is carried out. For example, the down-converting and quantizing of the signal may introduce errors or noise, such random noise (fluctuations) that may distort the signal and reduce its quality.

For example, the filtering 530 includes passing the signal through a digital filter that allows certain frequencies to pass while attenuating others, such as a finite response (FIR) filter, which may be implemented based on an FPGA (as depicted in subfigure 5(d)), without limiting the present disclosure in that regard. In the present example, an FPGA is chosen due to its parallel processing capability and reconfigurability.

An FIR filter's output y[n] may be a weighted sum of a current input value and a finite number of previous input values $x[n]$, e.g.:

$$y[n] = \sum_{k=0}^{N-1} h[k]x[n-k] \tag{13}$$

where $h[k]$ are the filter coefficients and N is the filter order.

The filtered signal is also referred to as a clock signal according to the present disclosure. However, in some examples, any other intermediate signal or the original (analog) signal may be referred to as the clock signal. After filtering, the clock signal may be ready for integration into a cellular network or for any other use. The clock signal may further be modulated, or other processes may be carried out to ensure efficient transmission and reception.

According to the present disclosure, Quantum Nonlinear Synchronization (QNS) may be provided within an optical lattice framework, significantly enhancing synchronization processes across a tri-node (or more) network. By leveraging the interactions of non-linear atoms within advanced optical resonators and controlling them with a (single-source) electromagnetic field, the system may achieve precise locking of each atom's position. This control may induce collective frequency oscillations (limit cycle oscillations), enabling femtosecond-level accuracy in time synchronization for communication networks. Consequently, this advancement may facilitate the creation of a global network with femtosecond-accurate clock distribution, vastly improving synchronization reliability and performance. Thereby, timekeeping may be improved and unprecedented stability and efficiency in synchronization on a global scale may be ensured.

Time synchronization may coordinates clocks in different devices, systems, or networks to the same time reference, crucial for modern technologies and applications. It may ensure unified operation across systems, maintaining data integrity and managing coordinated actions. The required precision may vary from milliseconds in computer networks to nanoseconds in satellite communications. Common protocols include Network Time Protocol (NTP) that synchronizes within tens of milliseconds over the internet; Precision Time Protocol (PTP), e.g., IEEE 1588, for sub-microsecond accuracy within networks; GPS (global positioning system) Time Transfer, in which GPS signals may be used for high-precision applications, reaching accuracies within nanoseconds. However, according to the present disclosure, even higher synchronization may be achieved by leveraging quantum mechanics.

According to the present disclosure, at least the following effects may be achieved: Femtosecond-level accuracy may be achieved in time synchronization. Enhanced system stability through non-linear dynamics and external optical field control may be achieved. Global (or national or international) network synchronization with unprecedented reliability may be provided. The optical lattice clock may mitigate issues such as thermal effects and gravitational redshift that affect traditional OLC implementations and thus, reduced environmental sensitivity may be achieved. The optical lattice clock may be integrated in existing networks without having to change the network infrastructure, thereby enhancing overall network synchronization. QNS may be used across a distributed network for ensuring stable and precise synchronization of the network even in the presence of environmental perturbations and network challenges.

The aspects and features described in relation to a particular one of the previous examples may also be combined with one or more of the further examples to replace an identical or similar feature of that further example or to additionally introduce the features into the further example.

It is further understood that the disclosure of several steps, processes, operations or functions disclosed in the description or claims shall not be construed to imply that these operations are necessarily dependent on the order described, unless explicitly stated in the individual case or necessary for technical reasons. Therefore, the previous description does not limit the execution of several steps or functions to a certain order. Furthermore, in further examples, a single step, function, process or operation may include and/or be broken up into several sub-steps, -functions, -processes or -operations.

If some aspects have been described in relation to a device or system, these aspects should also be understood as a description of the corresponding method. For example, a block, device or functional aspect of the device or system may correspond to a feature, such as a method step, of the corresponding method. Accordingly, aspects described in relation to a method shall also be understood as a description of a corresponding block, a corresponding element, a property or a functional feature of a corresponding device or a corresponding system.

The following claims are hereby incorporated in the detailed description, wherein each claim may stand on its own as a separate example. It should also be noted that although in the claims a dependent claim refers to a particular combination with one or more other claims, other examples may also include a combination of the dependent claim with the subject matter of any other dependent or independent claim. Such combinations are hereby explicitly proposed, unless it is stated in the individual case that a particular combination is not intended. Furthermore, features of a claim should also be included for any other independent claim, even if that claim is not directly defined as dependent on that other independent claim.

## Claims

1.  An optical lattice clock (100) comprising:

    multiple optical resonators (110, 120, 130);
    an optical system configured to pump photons into the optical resonators (110, 120, 130) to form an optical lattice in each of the optical resonators (110, 120, 130) for spatially trapping non-linear atoms in the optical resonators (110, 120, 130),
    wherein the optical system is configured to:

    pump the photons based on two-photon losses in the optical lattice clock to drive the non-linear atoms in the optical resonators (110, 120, 130) into synchronized limit cycle oscillations;
    wherein the optical lattice clock is further configured to:
    generate a clock signal based on a probed clock transition of the non-linear atoms, wherein the clock transition is probed when the limit cycle oscillations of the non-linear atoms in the optical resonators (110, 120, 130) are synchronized.

2.  The optical lattice clock of claim 1, wherein the optical system is configured to pump the photons further based on single-photon losses of the non-linear atoms to drive the non-linear atoms in the optical resonators (110, 120, 130) into the synchronized limit cycle oscillations.

3.  The optical lattice clock of claim 2, wherein the optical system is configured to pump the photons using a computational model that receives the single-photon losses and two-photon losses as input, and wherein the computational model is configured to model Lindblad dissipative processes for single-photon losses and two-photon losses of the non-linear atoms and to model Hamiltonian dynamics of the non-linear atoms.

4.  The optical lattice clock of any one of claims 1 to 3, wherein the non-linear atoms are Thulium atoms, and/or wherein the pumped photons have a wavelength of 814.5 nm.

5.  The optical lattice clock of claim 4, wherein the measured clock transition is at 1.14 $\mu$m.

6.  The optical lattice clock of any one of claims 1 to 5, wherein, for pumping the photons, the optical system is configured continuously adjust at least one parameter of the optical system.

7.  The optical lattice clock of claim 6, wherein the optical system comprises:

    a lattice laser (140) configured to emit a laser beam;
    optical components (150, 160) configured to guide the laser beam of the lattice laser (140) along a respective optical path from the laser to a respective one of the multiple optical resonators (110, 120, 130) for pumping the photons into the optical resonators (110, 120, 130),
    wherein the at least one parameter is at least one of a parameter of the laser beam and a parameter of the respective optical path.

8. The optical lattice clock of claim 7, wherein the optical lattice clock is further configured to:
   estimate the two-photon losses based on a measured property of the laser beam.

9. The optical lattice clock of any one of claims 1 to 8, wherein, for generating the clock signal, the optical lattice clock is configured to:

   tune, until a predefined criterion is satisfied, a frequency of a laser beam of a clock laser used for probing the non-linear atoms;
   generate a timing reference signal based on counted oscillations of the laser beam of the clock laser, the counted oscillations being counted when the predefined criterion is satisfied;
   down-convert the timing reference signal to obtain a down-converted timing reference signal;
   quantize the down-converted timing reference signal to obtain a quantized timing reference signal; and
   filter the quantized timing reference signal to obtain the clock signal.

10. The optical lattice clock of any one of claims 1 to 9, wherein the multiple optical resonators (110, 120, 130) are at least three optical resonators.

11. The optical lattice clock of any one of claims 1 to 10, wherein the optical lattice clock is further configured to:
    transmit the clock signal to a network component (210) of a cellular network (200).

12. Use of a clock signal generated by an optical lattice clock (100) according to any one of claims 1 to 11 for providing a network function in a cellular network (200).

13. A cellular network (200) comprising an optical lattice clock (100) according to any one of claims 1 to 11.

14. The cellular network of claim 13, further comprising a network (210) component configured to:

    receive the clock signal from the optical lattice clock (100); and
    provide a network function of the cellular network (200) based on the clock signal.

15. A method (300) for operating an optical lattice clock (100), the method comprising:

    pumping photons into multiple optical resonators (110, 120, 130) to form an optical lattice in each of the optical resonators (110, 120, 130) for spatially trapping non-linear atoms in the optical resonators, wherein the photons are pumped based on two-photon losses in the optical lattice clock to drive the non-linear atoms in the optical resonators (110, 120, 130) into synchronized limit cycle oscillations ; and
    generating a clock signal based on a probed clock transition of the non-linear atoms, wherein the clock transition is probed when the limit cycle oscillations of the non-linear atoms in the optical resonators (110, 120, 130) are synchronized.

EP 4 718 172 A1

$\gamma_1, \gamma_2$

$\gamma_1, \gamma_2$

$\gamma_1, \gamma_2$

130

120

160

110

150

100

140

170

FIG. 1

Fig. 2

Fig. 3

## FIG. 4

EP 4 718 172 A1

(a)

(b) Frequency Domain Spectral Lines

(c) 500

(d)

FIG. 5

EP 4 718 172 A1

Europäisches Patentamt
European Patent Office
Office européen des brevets

# EUROPEAN SEARCH REPORT

**Application Number**

EP 24 20 3556

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JONAS LARSON ET AL: "The Jaynes-Cummings model and its descendants", ARXIV.ORG, CORNELL UNIVERSITY LIBRARY, 201 OLIN LIBRARY CORNELL UNIVERSITY ITHACA, NY 14853, 1 February 2022 (2022-02-01), XP091148917, DOI: 10.1088/978-0-7503-3447-1 * page 185; figure 69 * ----- | 1-15 | INV. G04F5/14 B82B1/00 B82Y10/00 B82Y20/00 G06N10/40 G21K1/00 H03L7/26 |
| A | LIYUN ZHANG ET AL: "Observing Quantum Synchronization of a Single Trapped-Ion Qubit", ARXIV.ORG, CORNELL UNIVERSITY LIBRARY, 201 OLIN LIBRARY CORNELL UNIVERSITY ITHACA, NY 14853, 12 May 2022 (2022-05-12), XP091224828, * page 1 - page 2; figure 1 * ----- | 1-15 | |

| | | | TECHNICAL FIELDS SEARCHED (IPC) |
|---|---|---|---|
| | | | G04F B82Y H05G H03L G06N B82B G21K |

The present search report has been drawn up for all claims

| Place of search | Date of completion of the search | Examiner |
|---|---|---|
| The Hague | 20 February 2025 | Mérimèche, Habib |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
..............................................................................................
& : member of the same patent family, corresponding
    document

EPO FORM 1503 03.82 (P04C01)